# EUROPÄISCHE PATENTSCHRIFT

(11) **EP 0 471 952 B1**
(45) Veröffentlichungstag und Bekanntmachung des Hinweises auf die Patenterteilung: **15.11.1995**
(21) Anmeldenummer: 91110806.6
(22) Anmeldetag: 29.06.1991
(51) Int. Cl.: H04B 1/26, H04B 1/50, H03D 7/16

(54) **Sende- und N-fach-Superhet-Empfangseinrichtung für ein Gerät der Nachrichtentechnik**
Transmitter- and multiple conversion superhet receiver for a telecommunication device
Emetteur et récepteur superhétérodyne à multiple conversion de fréquence pour un appareil de télécommunication

(30) Priorität: 04.07.1990 DE 4021294
(43) Veröffentlichungstag der Anmeldung: 26.02.1992
(73) Patentinhaber: Grundig E.M.V. Elektro-Mechanische Versuchsanstalt Max Grundig GmbH & Co. KG, 90762 Fürth (DE)
(72) Erfinder: Bauerschmidt, Werner, Grundig E.M.V., Max Grundig, W-8510 Fuerth (DE)

(56) Entgegenhaltungen:
- DE-B- 1 002 805
- DE-B- 1 206 499
- DE-B- 1 206 499
- FR-A- 2 483 085

## Beschreibung

### SENDE- UND N-FACH-SUPERHET-EMPFANGSEINRICHTUNG FÜR EIN GERÄT DER NACHRICHTENTECHNIK

Die Erfindung betrifft eine Sende- und N-fach-Superhet-Empfangseinrichtungstechnik gemäß dem Oberbegriff des Patentanspruchs 1.

N-fach-Superhet-Empfänger, d.h. Empfänger mit n-facher Frequenzumsetzung, sind seit langem bekannt und werden vorzugsweise in Funksprechgeräten benutzt. Beispielsweise ist in der EP-B1-0 089 649 ein Funkgerät mit einem Einfach-Superhet-Empfänger beschrieben, bei dem die hochfrequente Trägerschwingung des Sendeoszillators jeweils zwischen den Empfangsfrequenzen von zwei benachbarten Funkkanälen liegt und einem Mischer zugeführt wird. Durch die doppelte Ausnutzung der im Senderzweig erzeugten Trägerschwingung kann nicht nur ein Oszillator im Empfängerzweig entfallen, sondern zusätzlich können Interferenzschwingungen, welche sonst in einem Gerät mit mehreren Oszillatoren auftreten würden, vermieden werden.

Ein solches Schaltungskonzept ist jedoch mit dem Nachteil verbunden, daß das Zwischenfrequenzsignal neben der Modulation des empfangenen Signals auch vom Sender stammende Modulationssignalkomponenten enthält.

Um das Empfangssignal, z.B. ein Sprachsignal, ohne Störungen, insbesondere ohne Übersprechstörung am Funkgerät über Lautsprecher hörbar zu machen, müssen die von der Sendeeinrichtung des Funkgeräts kommenden Modulationssignalkomponenten auf der Empfängerseite möglichst gut beseitigt bzw. unterdrückt werden.

In der Praxis haben sich zwei verschiedene Verfahren bewährt. Bei dem ersten Verfahren erfolgt die Subtraktion des dem Sendemodulator zugeführten Signals vom Ausgangssignal des Demodulators in der Niederfrequenzebene und beim zweiten Verfahren wird eine Modulation des zweiten Empfangsmischers (Ummischung von der ersten in die zweite Zwischenfrequenzlage) mit einem zur Modulation des Sendeoszillators gegenphasigen Signal. Auch Kombinationen der beiden Verfahren sind bekannt und beispielsweise in der DE-AS 1.002.805 ausführlich erläutert.

Das aus der DE-AS 1.002.805 bekannte Funksprechgerät soll als Funkrelaisstelle einsetzbar oder mit einer Drahtfernsprechleitung in Verbindung bringbar sein. Dabei wird die mit dem eigenen Signal modulierte hochfrequente Trägerschwingung des Senderzweiges außer zur Bildung der auszustrahlenden Sendeschwingung auch zur Überlagerung mit der empfangenen Schwingung und zur Zwischenfrequenzbildung im Empfängerzweig benutzt. Diese aus dem Senderzweig entnommene Überlagerungsschwingung trägt die dem abgehenden Signal entsprechende Modulation. Zum Kompensieren der durch das Modulationssignal verursachten Modulationskomponente sind beim Gegenstand der DE-AS 1.002.805 zwei Ausführungsformen einer Kompensiereinrichtung beschrieben, welche zwischen Sender- und Empfängerzweig angeordnet sind und jweils einen Verstärker und ein Phasendrehglied aufweisen.

Bei einer dem ersten Verfahren entsprechenden ersten Ausführungsform wird also eine rein modulationsfrequent wirksame Kompensation erzielt, während bei der zweiten Ausführungsform entsprechend dem zweiten Verfahren die Kompensation mit einem zusätzlichen Modulationsvorgang erzielt wird.

Das erste Verfahren weist den Vorteil auf, daß die einzelnen Bauelemente nur für den Einsatz im Niederfrequenzbereich ausgelegt sein müssen; d.h. zur Kompensation können relativ einfache, kostengünstig erhältliche Bauelemente benutzt werden. Von Nachteil ist allerdings, daß die durch die ZF-Filter verursachten Laufzeiten mit Hilfe von Laufzeitgliedern ausgeglichen werden müssen. Dies erfordert wieder einen relativ hohen Schaltungsaufwand und macht einen Abgleich der Kompensiereinrichtung erforderlich.

Das zweite Verfahren weist den Vorteil auf, daß Modulations- und Kompensationssignal gleichzeitig das zweite Zwischenfrequenzfilter durchlaufen. Im Vergleich zum ersten Verfahren wird die Kompensation der verbleibenden Laufzeitunterschiede wesentlich vereinfacht. Von Nachteil ist allerdings, daß die Frequenz des zweiten Empfangsoszillators sehr konstant sein muß. Deshalb wird als zweiter Empfangsoszillator ein hochkonstanter Quarzoszillator benutzt. Um einen solchen Quarzoszillator zu modulieren, ist jedoch ein relativ hoher Schaltungsaufwand erforderlich. Weiterhin ist von Nachteil, daß keine lineare Modulatorkennlinie erzeugt werden kann.

Weiterhin ist aus der EP-B1-0 135 816 eine Sende- und eine Superhet-Empfangseinrichtung bekannt, bei der die Kompensiereinrichtung einen Modulator aufweist. Das modulierte Ausgangssignal des Sendeoszillators, d.h. das Sendesignal, wird im Modulator mit dem Kompensationssignal (welches nach dem Durchlaufen eines Verstärkers und diesem nachgeordneten Phasendrehglieds an dessen Ausgang auftritt) so moduliert, daß der Superhet-Empfangseinrichtung ein im wesentlichen unmoduliertes Signal zugeführt wird. Die Frequenz dieses Signals entspricht der Frequenz des Sendeoszillators.

Schließlich ist aus der DE-B-1 206 499 ein FM-Gegensprech-Funkgerät mit einem Empfänger mit mehrfacher Überlagerung bekannt, bei dem die modulierte Frequenz des zugehörigen Senders als erste Überlagerungsfrequenz dient. Unter Ausnutzung des unter dem Namen "Stabilidyne" bekannten Prinzips, wird zur Unterdrückung der Modulation eines Senders -die auf das empfangene Signal wirkt- durch Mischung der modulierten Sendefrequenz mit einer von einem gesonderten Oszillator erzeugten konstanten Frequenz eine Frequenz f_{M} gebildet. Diese Frequenz f_{M} erzeugt in einer Mischstufe mit der ersten Zwischenfrequenz die von der Frequenzmodulation oder von sonstigen Änderungen der Sendefrequenz unabhängige zweite Zwischenfrequenz des Empfängers. Die auf diese Frequenz f_{M} und auf die erste Zwischenfrequenz abgestimmten Verstärker weisen den gleichen Phasengang auf.

Der Erfindung liegt die Aufgabe zugrunde, eine Sendeeinrichtung mit damit verbundener N-fach-Superhet-Empfangseinrichtung für ein Gerät der Nachrichtentechnik derart auszugestalten, daß das Zwischenfrequenzsignal neben der Modulation des Empfangssignals nicht mehr von der Sendeeinrichtung stammende Modulationssignalkomponenten enthält.

Diese Aufgabe wird bei einer gattungsgemäßen Sende- und Empfangseinrichtung durch die Merkmale des kennzeichnenden Teils des Patentanspruchs 1 gelöst.

Die erfindungsgemäß Sende- und Empfangseinrichtung weist den Vorteil auf, daß der sonst in einer 2-fach-Superhet-Empfangseinrichtung benötigte zweite Quarzoszillator bzw. Oszillatorfrequenz durch die Kompensiereinrichtung zur Verfügung gestellt wird. Betrag und Phase der Modulation der Oszillatorfrequenz des spannungsgesteuerten Oszillators in der Kompensiereinrichtung können dabei so gewählt werden, daß die durch den ersten Empfängeroszillator bzw. Sendeoszillator verursachte Modulation im zweiten Zwischenfrequenzbereich nicht mehr erscheint. Weiterhin ist von Vorteil, daß der Frequenzhub im Zwischenfrequenzbereich reduziert ist. Ein weiterer Vorteil der N-fach-Superhet-Empfangseinrichtung liegt darin, daß diese eine hohe Nachbarkanalselektion aufweist, so daß ein breiter Anwendungsbereich für in im Duplexbetrieb arbeitende Geräte, z.B. beim Autotelefon, Betriebsfunk, schnurloses Telefon, gegeben ist.

Die Ausführungsform der Sende-Empfangseinrichtung gemäß Patentanspruch 2 weist den Vorteil auf, daß eine annähernd lineare Steuerkennlinie für den spannungsgesteuerten Oszillator erzeugt werden kann. Weiterhin ist von Vorteil, daß durch den Frequenzdiskriminator die sonst fehlende Stabilität des spannungsgesteuerten Oszillators sichergestellt ist.

Weist die Kompensiereinrichtung gemäß Patentanspruch 3 einen Mischer auf, welcher mit einem Quarzoszillator verbunden ist, so muß der Frequenzdiskriminator - im Vergleich zur Ausführungsform nach Patentanspruch 2 - nur für den Einsatz in einem niedrigeren Frequenzbereich ausgelegt sein. Ein solcher Frequenzdiskriminator ist kostengünstig im Handel erhältlich, und weist zudem den Vorteil auf, daß dieser frequenzstabil ist.

Die Ausführungsform der Sende-Empfangseinrichtung gemäß Patentanspruch 4 weist den Vorteil auf, daß auf einfache Art und Weise der Schaltungsaufwand reduziert ist. Im Vergleich zur Ausführungsform nach Patentanspruch 3 ist der Mischer entfallen.

Weist die Kompensiereinrichtung gemäß Patentanspruch 5 einen Quarzoszillator auf, welcher als selbstschwingender Mischer ausgestaltet ist, so sind im Mischerprodukt keine nichtharmonischen Frequenzen enthalten (d.h. die spektrale Reinheit der Frequenz am Ausgang des spannungsgesteuerten Oszillators ist gewahrt).

Die Erfindung wird im folgenden anhand in der Zeichnung dargesteller Ausführungsformen näher beschrieben und erläutert. Es zeigen:
- Fig. 1: eine erste Ausführungsform der erfindungsgemäßen Sende-Empfangseinrichtung, bei der die Kompensiereinrichtung eine Frequenzregelschaltung mit einem spannungsgesteuerten Oszillator enthält,
- Fig. 2: eine zweite Ausführungsform, welche zusätzlich einen Mischer und einen damit verbundenen Quarzoszillator aufweist,
- Fig. 3: eine dritte Ausführungsform, bei der der spannungsgesteuerte Oszillator als selbstschwingender Oszillator ausgestaltet ist und
- Fig. 4: eine vierte Ausführungsform, bei der der Quarzoszillator die Funktion eines selbstschwingenden Mischers aufweist.

Für die erfindungsgemäße Sende- und Empfangseinrichtung ist ein breiter Anwendungsbereich, insbesondere bei im Duplexbetrieb arbeitenden Geräten der Nachrichtentechnik gegeben. Die verschiedenen Ausführungsformen sind nicht an ein spezielles Übertragungsverfahren (Modulations- und Codierungsverfahren) gebunden. Bei der folgenden Beschreibung wird von der Anwendung in einem schnurlosen Telefon ausgegangen.

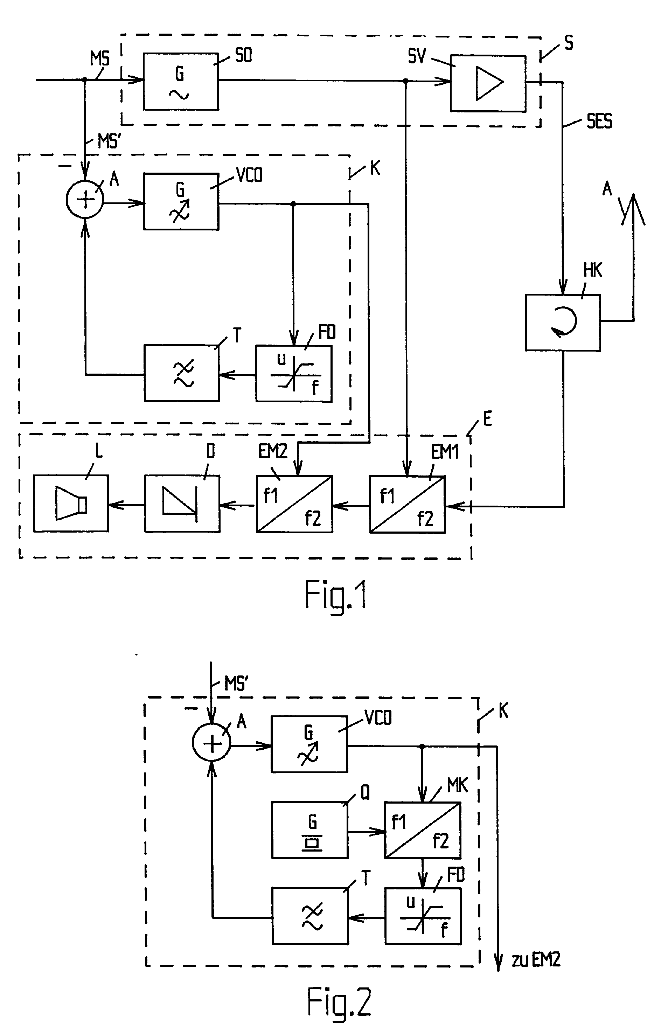

Fig. 1 zeigt das Blockschaltbild einer ersten Ausführungsform der erfindungsgemäßen Sende- und Empfangseinrichtung.

Die Informationsübertragung zwischen einer Basisstation und der zugehörigen Mobilstation G des schnurlosen Telefonapparates erfolgt über ein Funkübertragungskanalpaar. Die Basisstation wird mittels einer Verbindungsdose an das Fernmeldenetz angeschlossen, so daß für den Benutzer beispielsweise der Zugang zum öffentlichen Fernsprechnetz möglich ist.

Dadurch, daß die Basisstation und die Mobilstation G über einen Funkübertragungskanal miteinander in Verbindung stehen, ist der Bewegungsbereich des Benutzers auf einen Umkreis bis zu 200 m zum jeweiligen Anschluß (Verbindungsdose) erweitert.

In der Bundesrepublik Deutschland stehen derzeit für die Informationsübertragung 80 Funkkanäle zur Verfügung, welche im Frequenzbereich von 900 MHz liegen. Mit der obengenannten Übertragungsreichweite ergibt sich für die Belegung des gleichen Funkkanals durch zueinander benachbarte schnurlose Telefonapparate eine geringe Belegwahrscheinlichkeit. Liegt ein Verbindungswunsch vor, so wird von einer im Empfänger E von Mobilstation G und Basisstation angeordneten Sendersuchlaufeinrichtung ein Suchlauf nach einem freien Funkübertragungskanal gestartet und das Funkübertragungskanalpaar belegt. Um sicherzustellen, daß die zwischen den beiden Stationen des schnurlosen Telefonapparates übertragenen Nachrichten von keinem anderen schnurlosen Telefonapparat mitgehört werden können, daß die Gebührenzuordnung sichergestellt ist und daß die Zuordnung der Funkübertragungskanalpaare eindeutig ist, ist jedem schnurlosen Telefonapparat eine Kennung zugeordnet, welche von der Fernsprechteilnehmernummer des Fernsprechteilnehmers unabhängig ist.

Bei der Basisstation löst ein von der zugehörigen Steuereinrichtung erkannter ankommender Ruf auf der Amtsleitung die Funkkanalsuche aus. Durch Betätigen der Gabelumschalt-Taste wird in der Mobilstation G die Funkkanalsuche eingeleitet. In der EB-B1-0 074 940 ist der dabei vorgenommene Kennungsaustausch näher beschrieben und erläutert. Ein als frei erkannter Funkübertragungskanal wird belegt, der Sender S aktiviert und die Kennung als Datentelegramm über den Funkübertragungskanal gesendet. Nach dem Senden jeder Kennung wird auf ein Quittungstelegramm (Kennung) der entsprechenden Gegenstation gewartet. Wird die Kennung (Quittungstelegramm) der Gegenstation empfangen, so wird diese von einer in den jeweiligen Stationen angeordneten Einrichtung mit der eigenen Kennung verglichen. Bei Übereinstimmung wird von der mit der Einrichtung verbundenen Steuereinrichtung die Verbindung durchgeschaltet, die Kennungsausgabe eingestellt und die bestehende Funkverbindung überwacht.

Eine weitere Anwendung für schnurlose Telefonapparate ist bei öffentlichen Telepoint-Diensten gegeben. Beim Telepoint-Dienst sind die Basisstationen an öffentlichen Stellen, wie etwa an großen Plätzen, Bahnhöfen, Flughäfen, Einkaufszentren, Autobahnraststätten, usw. installiert. Der Besitzer eines geeigneten Handapparates (Mobilteil) kann im Umkreis von einigen 100 Metern einer solchen Basisstation an das öffentliche Fernsprechnetz gelangen, um Gespräche zu führen.

Die Sendeeinrichtung S enthält einen Sendeoszillator SO, welcher durch ein Modulationssignal MS moduliert wird. Der Sendeoszillator SO ist zur Ummischung des über Sende- und Empfangsantenne A und Hybridkoppeler HK zugeführten Empfangssignals ES in eine erste Zwischenfrequenzlage mit einem ersten Empfangsmischer EM1 verbunden. Die erste Zwischenfrequenz entspricht dem Duplexabstand zwischen Sende- und Empfangsfrequenz des Nachrichtenübertragungssystems. Mit einer zwischen Sende- und Empfangseinrichtung S, E angeordneten Kompensiereinrichtung K wird ein zweiter Empfangsmischer EM2 mit einem zur Modulation des Sendeoszillators SO gegenphasigen Signal moduliert, wobei das Modulationssignal MS der Kompensiereinrichtung zugeführt wird. Die Kompensiereinrichtung K enthält eine Frequenzregel-Schaltung mit einem spannungsgesteuerten Oszillator VCO, dessen Sollfrequenz der Summe oder der Differenz aus erster und zweiter Zwischenfrequenz entspricht und welcher mit dem zweiten Empfangsmischer EM2 verbunden ist. Bei der in Fig. 1 dargestellten Ausführungsform ist der spannungsgesteuerte Oszillator VCO sowohl mit einer Addierstufe A als auch mit einem Frequenzdiskriminator FD verbunden, an dessen Ausgang ein Tiefpaßfilter T angeschlossen ist. Den beiden Eingängen der Addierstufe A werden das gegenphasige Modulationssignal MS′ und das Ausgangssignal O des Tiefpaßfilters T zugeführt. Mit dem zweiten Emfangsmischer EM2 ist ein Demodulator D verbunden, an dessen Ausgang, z.B. eine Sprachausgabeeinrichtung L angeordnet ist. Weiterhin enthält die 2-fach-Superhet-Empfangseinrichtung E zwischen erstem und zweitem Empfangsmischer EM1, EM2 und zwischen zweitem Empfangsmischer EM2 und Demodulator D angeordnete ZF-Filter, welche zur Übersichtlichkeit in Fig. 1 nicht dargestellt sind. Schließlich ist zwischen Sendeoszillator SO und Hybridkoppler HK ein Sendeverstärker SV angeordnet.

Durch die Kompensiereinrichtung K wird sichergestellt, daß das Zwischenfrequenzsignal neben der Modulation des Empfangssignals nicht mehr von der Sendeeinrichtung S stammende Modulationssignalkomponenten enthält.

Weiterhin ist von Vorteil, daß der sonst in einer 2-fach-Superhet-Empfangseinrichtung E benötigte zweite Quarzoszillator bzw Oszillatorfrequenz durch die Kompensiereinrichtung K zur Verfügung gestellt wird. Betrag und Phase der Modulation der Oszillatorfrequenz des spannungsgesteuerten Oszillators VCO in der Kompensiereinrichtung K können dabei so gewählt werden, daß die durch den ersten Empfängeroszillator bzw. Sendeoszillator SO verursachte Modulation im zweiten Zwischenfrequenzbereich nicht mehr erscheint. Weiterhin ist von Vorteil, daß der Frequenzhub im Zwischenfrequenzbereich reduziert ist und daß eine annährend lineare Steuerkennlinie für den spannungsgesteuerten Oszillator VCO erzeugt werden kann. Durch den Frequenzdiskriminator FD wird die sonst fehlende Stabilität des spannungsgesteuerten Oszillators VCO sichergestellt.

Bei der in Fig. 2 dargestellten zweiten Ausführungsform weist die Kompensiereinrichtung K zusätzlich einen Mischer MK auf, welcher zwischen dem spannungsgesteuerten Oszillator VCO und dem Frequenzdiskriminator FD angeordnet und mit einem Quarzoszillator Q verbunden ist. Der Frequenzdiskriminator FS muß infolge der Frequenzumsetzung nur für den Einsatz in einem niedrigen Frequenzbereich angelegt sein. Ein solcher Frequenzdiskriminator ist relativ preiswert und frequenzstabil.

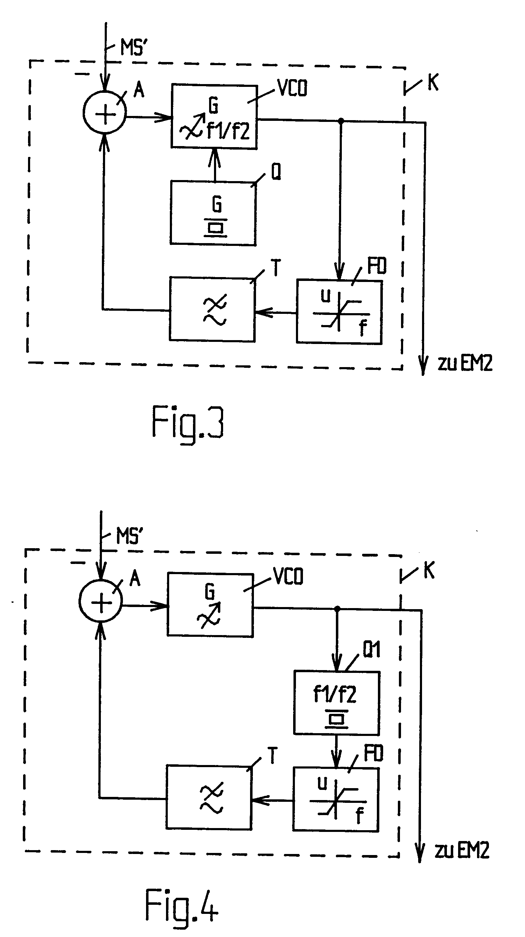

Bei der in Fig. 3 dargestellten dritten Ausführungsform ist der spannungsgesteuerte Oszillator VCO als selbstschwingender Mischer ausgestaltet. Ein weiterer Eingang des spannungsgesteuerten Oszillators VCO ist mit einem Quarzoszillator Q verbunden. Dadurch ist auf einfache Art und Weise (durch den fehlenden Mischer MK) der Schaltungsaufwand reduziert, nachteilig kann jedoch sein, daß nichtharmonische Frequenzen auftreten können.

Diesen Nachteil weist die in Fig. 4 dargestellte Ausführungsform nicht auf. In der Kompensiereinrichtung K ist ein Quarzoszillator Q1 angeordnet, welcher als selbstschwingender Mischer ausgestaltet ist. Der Quarzoszillator Q1 ist sowohl mit dem spannungsgesteuerten Oszillator VCO als auch mit dem Frequenzdiskriminator FD verbunden, an dessen Ausgang ein Tiefpaßfilter T angeschlossen ist. Den beiden Eingängen der Addierstufe A werden das gegenphasige Modulationssignal MS′ und das Ausgangssignal O des Tiefpaßfilters T zugeführt.

## Patentansprüche

1. Sende- und N-fach-Superhet-Empfangseinrichtung (S,E) für ein Gerät der Nachrichtentechnik, insbesondere für ein in Voll-Duplexbetrieb arbeitendes Funkgerät eines Funkübertragungssystems oder Mobilteil eines schnurlosen Telefonapparats oder telepoinffähiges Mobilteil, mit einem Sendeoszillator (SO), welcher durch ein Modulationssignal (MS) moduliert wird und welcher zur Ummischung eines Empfangssignals (ES) in eine erste Zwischenfrequenzlage mit einem ersten Empfangsmischer (EM1) verbunden ist, wobei die erste Zwischenfrequenz dem Duplexabstand zwischen Sende- und Empfangsfrequenz des Nachrichtenübertragungssystems entspricht, und mit einer zwischen Sende- und Empfangseinrichtung (S,E) angeordneten Kompensiereinrichtung (K), welche zur Modulation eines zweiten Empfangsmischers (EM2) mit diesem verbunden ist und an dessen Ausgang eine zweite Zwischenfrequenz anliegt,
**dadurch gekennzeichnet,** daß ein zum Modulationssignal (MS) gegenphasiges Modulationssignal (MS′) der Kompensiereinrichtung (K) zugeführt wird und die Kompensiereinrichtung (K) eine Frequenzregel-Schaltung mit einem spannungsgesteuerten Oszillator (VCO) enthält, dessen Sollfrequenz der Summe oder der Differenz aus erster und zweiter Zwischenfrequenz entspricht, und welcher mit dem zweiten Empfangsmischer (EM2) verbunden ist.

2. Sende- und Empfangseinrichtung nach Anspruch 1,
**dadurch gekennzeichnet,**
daß der spannungsgesteuerte Oszillator (VCO) sowohl mit einer Addierstufe (A) als auch mit einem Frequenzdiskriminator (FD) verbunden ist, an dessen Ausgang ein Tiefpaßfilter (T) angeschlossen ist und daß den beiden Eingängen der Addierstufe (A) das gegenphasige Modulationssignal (MS′) und das Ausgangssignal (O) des Tiefpaßfilters (T) zugeführt werden.

3. Sende- und Empfangseinrichtung nach Anspruch 2,
**dadurch gekennzeichnet,**
daß die Kompensiereinrichtung (K) einen Mischer (MK) aufweist, welcher zwischen dem spannungsgesteuerten Oszillator (VCO) und dem Frequenzdiskriminator (FD) angeordnet und mit einem Quarzoszillator (Q) verbunden ist.

4. Sende- und Empfangseinrichtung nach Anspruch 2,
**dadurch gekennzeichnet,**
daß der spannungsgesteuerte Oszillator (VCO) als selbstschwingender Mischer ausgestaltet ist und daß ein weiterer Eingang des spannungsgesteuerten Oszillators (VCO) mit einem Quarzoszillator (Q) verbunden ist.

5. Sende- und Empfangseinrichtung nach Anspruch 1,
**dadurch gekennzeichnet,**
daß in der Kompensiereinrichtung (K) ein Quarzoszillator (Q1) angeordnet ist, welcher als selbstschwingender Mischer ausgestaltet ist und welcher sowohl mit dem spannungsgesteuerten Oszillator (VCO) als auch mit einem Frequenzdiskriminator (FD) verbunden ist, an dessen Ausgang ein Tiefpaßfilter (T) angeschlossen ist und daß den beiden Eingängen der Addierstufe (A) das gegenphasige Modulationssignal (MS′) und das Ausgangssignal (O) des Tiefpaßfilter (T) zugeführt werden.

## Claims

1. Transmitter and n-stage superhet receiver (S, E) for a telecommunications device, in particular for a transceiver of a radio transmission system operating in the full duplex mode, or for the mobile unit of a cordless telephone set or a Telepoint mobile unit, having a transmit oscillator (SO) which is modulated by a modulation signal (MS) and which is connected to a first receive mixer (EM1) for converting a receive signal (ES) into a first intermediate frequency, the first intermediate frequency corresponding to the duplex separation between the transmit and receive frequencies of the communication system, and having a compensating device (K) arranged between the transmitter and receiver (S, E), which compensating device (K) is connected to a second receive mixer (EM2) for modulating the second receive mixer (EM2), a second intermediate frequency appearing at the output of the latter, **characterised in that** a modulation signal (MS′) which is 180° out of phase with the modulation signal (MS) is fed to the compensating device (K) and the compensating device (K) contains a frequency control circuit having a voltage-controlled oscillator (VCO), whose reference frequency corresponds to the sum or the difference of the first and second intermediate frequencies, and which is connected to the second receive mixer (EM2).

2. Transmitter and receiver according to Claim 1, **characterised in that** the voltage-controlled oscillator (VCO) is connected to an adder stage (A) and to a frequency discriminator (FD) to whose output a low-pass filter (T) is connected, and that the 180° out-of-phase modulation signal (MS′) and the output signal (O) of the low-pass filter (T) are fed to both inputs of the adder stage (A).

3. Transmitter and receiver according to Claim 2, **characterised in that** the compensating device (K) has a mixer (MK) which is arranged between the voltage-controlled oscillator (VCO) and the frequency discriminator (FD) and is connected to a quartz oscillator (Q).

4. Transmitter and receiver according to Claim 2, **characterised in that** the voltage-controlled oscillator (VCO) is constructed as a free-running mixer, and that a further input of the voltage-controlled oscillator (VCO) is connected to a quartz oscillator (Q).

5. Transmitter and receiver according to Claim 1, **characterised in that** a quartz oscillator (Q1) which is constructed as a free-running mixer and which is connected to the voltage-controlled oscillator (VCO) and to a frequency discriminator (FD) to whose output is connected a low-pass filter (T), is arranged in the compensating device (K), and that the 180° out-of-phase modulation signal (MS′) and the output signal (O) of the low-pass filter (T) are fed to both inputs of the adder stage (A).

## Revendications

1. Dispositif d'émission et de réception superhétérodyne à N conversions (S,E) pour un appareil de la technique de transmission d'informations, notamment pour un appareil radio, qui fonctionne en duplex total, d'un système de transmission radio ou une partie mobile d'un téléphone sans fil ou une partie mobile permettant la transmission télépoint, comportant un oscillateur d'émission (SO), qui est modulé par un signal de modulation (MS) et qui, pour le mélange d'un signal de réception (ES) dans une première position à fréquence intermédiaire, est relié à un premier mélangeur de réception, la première fréquence intermédiaire correspondant à la distance duplex entre la fréquence d'émission et la fréquence de réception du système de transmission d'informations, et comportant un dispositif de compensation (K), qui est disposé entre le dispositif d'émission et de réception (S,N) et qui est relié à un second mélangeur de réception (EM2) pour la modulation de ce dernier et à la sortie duquel est présente une seconde fréquence intermédiaire,
caractérisé par le fait qu'un signal de modulation (MS′), qui est en opposition de phase avec le signal de modulation (MS), est envoyé au dispositif de compensation (K), et le dispositif de compensation (K) contient un circuit de régulation de fréquence possédant un oscillateur (VCO) commandé par la tension, dont la fréquence de consigne correspond à la somme ou à la différence des première et seconde fréquences intermédiaires et qui est relié au second mélangeur de réception (EM2).

2. Dispositif d'émission et de réception selon la revendication 1, caractérisé en ce que l'oscillateur (VCO) commandé par la tension est relié aussi bien à un étage additionneur (A) qu'à un discriminateur de fréquence (FD), à la sortie duquel est raccordé un filtre passe-bas (T), et que le signal de modulation en opposition de phase (MS′) et le signal de sortie (O) du filtre passe-bas (T) sont envoyés aux deux entrée de l'étage additionneur (A).

3. Dispositif d'émission et de réception selon la revendication 2, caractérisé en ce que le dispositif de compensation (K) comporte un mélangeur (MK), qui est disposé entre l'oscillateur (VCO) commandé par la tension et le discriminateur de fréquence (FD) et est relié à un oscillateur à quartz (Q).

4. Dispositif d'émission et de réception selon la revendication 2, caractérisé en ce que l'oscillateur (VCO) commandé par la tension est agencé sous la forme d'un mélangeur auto-oscillant et qu'une autre entrée de l'oscillateur (VCO) commandé par la tension est reliée à un oscillateur à quartz (Q).

5. Dispositif d'émission et de réception selon la revendication 1, caractérisé en ce que dans le dispositif de compensation (K) est disposé un oscillateur à quartz (Q1), qui est agencé sous la forme d'un mélangeur auto-oscillant et qui est relié aussi bien à l'oscillateur (VCO) commandé par la tension qu'à un discriminateur de fréquence (FD), à la sortie duquel est raccordé un filtre passe-bas (T), et que le signal de modulation en opposition de phase (MS′) et le signal de sortie (O) du filtre passe-bas (T) sont envoyés aux deux entrées de l'étage additionneur (A).
